(19) Europäisches Patentamt
European Patent Office
Office européen des brevets

(11) **EP 3 295 772 B1**

(12) **EUROPÄISCHE PATENTSCHRIFT**

(45) Veröffentlichungstag und Bekanntmachung des Hinweises auf die Patenterteilung:
**23.08.2023 Patentblatt 2023/34**

(21) Anmeldenummer: **16736755.6**

(22) Anmeldetag: **03.05.2016**

(51) Internationale Patentklassifikation (IPC):
**H05B 47/10** *(2020.01)* **H05B 45/375** *(2020.01)*

(52) Gemeinsame Patentklassifikation (CPC):
**H05B 47/10; H05B 45/375**

(86) Internationale Anmeldenummer:
**PCT/AT2016/050122**

(87) Internationale Veröffentlichungsnummer:
**WO 2016/179617 (17.11.2016 Gazette 2016/46)**

(54) **VERFAHREN ZUM SYMMETRIEREN VON ZWEIG-STRÖMEN IN PARALLELGESCHALTETEN ZWEIGEN EINER BELEUCHTUNGSVORRICHTUNG FÜR FAHRZEUGE**

METHOD OF BALANCING BRANCH-CURRENTS IN PARALLEL CONNECTED BRANCHES OF A LIGHTING DEVICE FOR VEHICLES

PROCÉDÉ D'ÉQUILIBRAGE DES COURANTS DANS DES BRANCHES CONNECTÉES EN PARALLÈLE D'UN DISPOSITIF D'ÉCLAIRAGE POUR VÉHICULES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.05.2015 AT 503792015**

(43) Veröffentlichungstag der Anmeldung:
**21.03.2018 Patentblatt 2018/12**

(73) Patentinhaber: ZKW Group GmbH
**3250 Wieselburg (AT)**

(72) Erfinder:
• **WEBER, Emanuel**
**2500 Baden (AT)**
• **KIESLINGER, Dietmar**
**2604 Theresienfeld (AT)**
• **BIESENBERGER, Martin**
**3680 Persenbeug (AT)**

(74) Vertreter: **Patentanwaltskanzlei Matschnig & Forsthuber OG**
**Biberstraße 22**
**Postfach 36**
**1010 Wien (AT)**

(56) Entgegenhaltungen:
WO-A2-2014/023742 DE-A1-102008 033 176
DE-A1-102011 078 620 DE-A1-102012 211 828
DE-A1-102013 111 510 JP-A- S 639 325
US-A1- 2011 181 186 US-B1- 6 172 480

EP 3 295 772 B1

**Beschreibung**

Die Erfindung bezieht sich auf ein Verfahren zum Symmetrieren von Zweig-Strömen in parallelgeschalteten Zweigen einer Beleuchtungseinrichtung für Fahrzeuge im Zuge der Fertigung.

Der Einsatz von LEDs als Lichtquelle für Fahrzeug-Beleuchtungseinrichtungen mit unterschiedlichen Lichtfunktionen, bietet nicht zuletzt designmäßig neue Möglichkeiten bei der Auslegung der einzelnen Lichtfunktionen. Ein wesentlicher Parameter ist hierbei die LED-Anzahl, die pro Lichtfunktion eingesetzt wird. Durch die unterschiedlichen Designs beispielsweise von Scheinwerfern variiert auch die Anzahl der LEDs stark. Typische Anzahlen sind im Normalfall ein bis zehn in Serie betriebener LEDs je Lichtfunktion. Die Auslegung der Stromtreiber für derartige LED-Serienzweige hängt stark von der LED-Anzahl ab. Je nach Gesamtspannung des LED-Zweigs muss ein Abwärtswandler, ein Aufwärtswandler bzw. ein Auf-und-Abwärtswandler eingesetzt werden. Diese Vielfalt an notwendigen Wandler-Topologien verhindert jedoch den Einsatz kostenoptimierter Standardlösungen. Beispielsweise kann ein Abwärtswandler deutlich kosteneffizienter als ein Auf-und-Abwärtswandler ausgelegt werden.

Ein Ansatz um die LED-Spannung zu vereinheitlichen bzw. zu reduzieren ist die Parallelschaltung von LED-Zweigen, wodurch mit niedrigen Ausgangsspannungen der Wandler gearbeitet werden kann, mit dem Vorteil, dass einfach aufgebaute Abwärtswandler zur Anwendung kommen können. Je nach LED-Anzahl variiert lediglich der Ausgangstrom, der jedoch die Wahl der Topologie nicht wesentlich beeinflusst. Das Problem bei der Parallelschaltung von LEDs bzw. LED-Zweigen liegt jedoch in der fast immer erforderlichen Symmetrieren der LED-Ströme. Je nach LED-Type, LED-Spezifikation, LED-Binning-Klasse und auch abhängig von der Platzierung der LEDs und somit vom Leiterplatten-Layout stellen sich unterschiedliche Ströme durch die einzelnen LED-Zweige ein. (Unter "Binning" versteht man eine Klasseneinteilung einer LED-Produktion z.B. hinsichtlich Helligkeit, Lichtstrom, Farbton etc.) Diese unterschiedlichen Ströme können zu verschiedenen Nachteilen führen: die Stromasymmetrie kann eine thermische Überlastung von LEDs zur Folge haben und, damit verbunden, eine Verminderung deren Lebensdauer. Weiters ergeben unterschiedliche Ströme unterschiedliche LED-Helligkeiten und verschlechtern somit die Homogenität der Lichtverteilungen.

Das Dokument DE 10 2013 111510 A1, zeigt die Parallelschaltung von LED-Zweigen mit durch Schalter überbrückbare Vorwiderstände, insbesondere um den negativen Effekt von Fertigungstoleranzen abzumildern oder auszugleichen. Optional können diese Schalter auch von einer Steuereinheit elektronisch schaltbar sein.

Ein Schalter muss jedoch entweder mechanisch oder elektronisch betätigt werden, was automatisiert beim Bestücken einer Leiterplatte sicher nicht leicht möglich ist.

Die US 6,172,480 B1, betrifft ein Batterieladegerät, wobei gemäß dem genannten Stand der Technik zum Einstellen der genauen Batteriespannung ein Netzwerk von Trennwiderständen 13 verwendet wird. Durch das Wegbohren einer im Layout berücksichtigten Verbindung werden Trimm-Elemente zu- bzw. weggeschaltet. Dies kann auch während einer nicht näher erläuterten PCB-Test Phase durchgeführt werden. Wobei allerdings nichts darüber ausgesagt ist, was diese PCB-Test Phase ist. Mit der Bestromung von LEDs hat dieses Dokument D2 nichts gemeinsam.

Die WO 2014/023742 A2 behandelt die Parallelschaltung von LED-Zweigen, die je ein trimmbares Widerstandselement enthalten. Diese Widerstandselemente können Dünn- oder Dickfilmwiderstände sein, die mittels eines Lasers trimmbar sind. Die beschriebene Lösung ist relativ kompliziert, da man einerseits besondere Widerstände benötigt und andererseits ein Laserwerkzeug zum Trimmen.

Die EP 0942474 A2 beschreibt die Codierung einer LED durch drei Kontaktstellen, die in nicht beschriebener Weise geöffnet oder geschlossen werden können, damit diese LED mit einem von drei außen gelegenen Vorwiderständen verbunden werden kann.

Eine Aufgabe der Erfindung liegt darin, ein Symmetrierungsverfahren einer Beleuchtungseinrichtung anzugeben, die ein einfaches Symmetrieren bereits bei der Fertigung ermöglicht, um mit vergleichsweise geringen Versorgungsspannungen und somit mit kostengünstigen Spannungskonvertern bzw. Stromversorgungen arbeiten zu können. Diese Aufgabe wird mit einem Verfahren gemäß Anspruch 1 gelöst.

Dabei ist es oft zweckmäßig, falls die Serienschaltung eines auf der Leiterplatte angeordneten Leiterzugs und eines Nebenwiderstandes einem Vorwiderstand parallel geschaltet wird.

Auch kann in sinnvoller Weise vorgesehen sein, dass jeder Zweig zumindest zwei in Serie liegende Vorwiderstände aufweist, wobei zumindest ein Vorwiderstand jedes Zweiges durch einen auf einer Leiterplatte vorgesehenen Leiterzug überbrückt wird.

Besonders vorteilhaft kann es sein, wenn als Werkzeug ein Fräser eines Nutzentrenners für Leiterplatten verwendet wird.

Die Erfindung samt weiteren Vorteilen ist im Folgenden an Hand beispielsweiser Ausführungsformen näher erläutert, die in der Zeichnung veranschaulicht sind. In dieser zeigen

Fig. 1 eine erste beispielsweise Anordnung von parallelgeschalteten LED-Zweigen, die je zwei LED und einen Vorwiderstand in Serie geschaltet aufweisen,

Fig. 2 die Anordnung nach Fig. 1 nach Durchtrennen eines Leiterabschnittes,

Fig. 3 eine Anordnung wie nach Fig. 1 jedoch mit zwei Serienwiderständen in jedem Zweig,

Fig. 4 eine Anordnung wie nach Fig. 1 jedoch mit je vier gewichteten Serienwiderständen in jedem Zweig, wobei in einem Zweig ein Nebenwiderstand angedeutet ist, und

Fig. 5 eine Anordnung wie nach Fig. 1 jedoch mit vier gewichteten Nebenwiderständen in jedem Zweig, wobei in einem Zweig zusätzlich ein Serienwiderstand angedeutet ist.

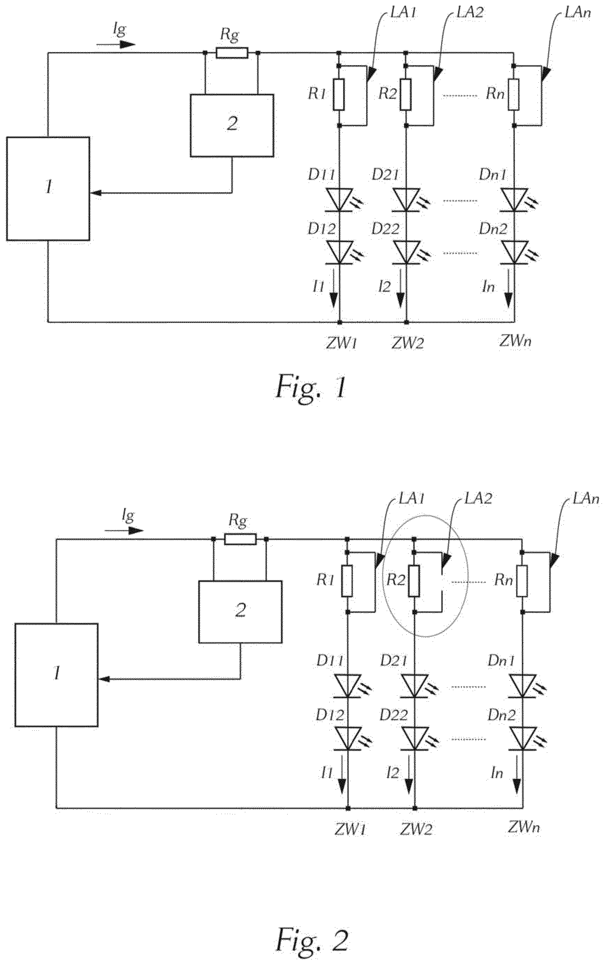

Es wird zunächst auf Fig. 1 Bezug genommen, welche von einer Beleuchtungseinrichtung für Fahrzeuge eine Anzahl von parallel liegenden Zweigen ZW1, ZW2 ... ZWn zeigt, wobei jeder Zweig im vorliegenden Fall einen Vorwiderstand R1, R2 ... Rn enthält, der in Serie mit im vorliegenden Fall zwei Leuchtdioden D11, D12; D21, D22 ... Dn1, Dn2 liegt. Die Parallelschaltung dieser Zweige ZW1 ... ZWn wird von einer Stromversorgung 1 gespeist, wobei diese Stromversorgung beispielsweise von einem Differenzverstärker 2 angesteuert wird, welcher den durch einen Serienwiderstand Rg fließenden Strom erfasst. Die Stromversorgung 1 ist zusammen mit dem Differenzverstärker 2 dazu eingerichtet, auf einen vorgebbaren konstanten Strom zu regeln und die Stromversorgung 1 enthält, hier nicht eingezeichnet, eine Spannungsquelle, z.B. einen KFZ-Akkumulator. Die Stromversorgung samt der genannten Regelung ist jedoch bekannt und auch nicht Gegenstand der vorliegenden Erfindung.

Wie Fig. 1 entnehmbar ist, ist jeder der Vorwiderstände R1, R2 ... Rn durch einen Leiterabschnitt LA1, LA2 ... LAn überbrückt, wobei dieser Leiterabschnitt LA1 ... LAn auf irgendeinem Leiterträger beliebiger Form vorgesehen ist. Bei praktischen und bewährten Ausführungsformen ist der Leiterabschnitt als Leiterzug bzw. Leiterbahn auf einer Leiterplatte ausgebildet, welche noch andere Bauteile tragen kann, insbesondere die Leuchtdioden und die Regelung bzw. einen Teil der Regelung für den Gesamtstrom Ig. Jeder die Vorwiderstände R1 ... Rn überbrückende Leiterabschnitt LA1 ... LAn ist so ausgebildet, dass er einfach durch ein Werkzeug durchtrennbar ist, wobei es klar ist, dass nach Durchtrennung eines entsprechenden Leiterabschnittes, beispielsweise des Leiterabschnittes LA2, der dazugehörige, überbrückte Vorwiderstand R2 wirksam wird.

Im Folgenden wird die Lösung der eingangs gestellten Aufgabe bzw. die Beseitigung der im Stand der Technik zugrunde liegenden Nachteile zunächst anhand der Fig. 1 und Fig. 2 erläutert.

Um kostengünstige Abwärtsregler zu erlauben, werden LED-Zweige im Gruppengrößen parallel geschaltet, wobei Voraussetzung dafür ist, dass die auftretende LED-Spannung jedes Zweiges in jedem Betriebszustand kleiner ist als die niedrigste Eingangsspannung. Im Falle eines 12 Volt-Bordnetzes ist der Eingangsspannungsbereich typischerweise von 9 bis 16 Volt spezifiziert. Bei einer typischen Maximalspannung einer LED von 3,5 Volt können in diesem Fall nur maximal zwei LEDs in einem Strang betrieben werden, wie dies in Fig. 1 und 2 gezeigt ist.

Wie bereits oben erwähnt, liegt das Problem bei der Parallelschaltung von LEDs darin, die Ströme der einzelnen Zweige zu symmetrieren, wobei der Gesamtstrom Ig der gesamten LED-Anordnung geregelt wird. Der tatsächliche Strom, der durch die jeweiligen LED-Zweige fließt, stellt sich aufgrund der LED-Vorwärtsspannungen ein. Dies kann jedoch abhängig von der Spezifikation der LEDs starke Unterschiede in der LED-Helligkeit bedeuten.

Die Vorwiderstände LA1 ... LAn mit den sie überbrückenden und durchtrennbaren Leiterabschnitten besitzen Werte, die je nach der vorliegenden LED-Spezifikation gewählt werden. Die Stromversorgung bzw. Regelung regelt nun auf einen Gesamtstrom Ig der LED-Anordnung, welcher sich aus der Addition der einzelnen LED-Zweigströme I1, I2 ... In ergibt, wobei die Serienwiderstände R1 ... Rn zunächst über die Leiterabschnitte LA1 ... LAn kurzgeschlossen sind. Im Allgemeinen befinden sich diese Serienwiderstände samt den als Leiterzügen ausgebildeten Leiterabschnitten auf dem Leiterplattenlayout.

Nach der Bestückung der Leiterplatte, jedoch vor der Vereinzelung der Leiterplatten im Nutzentrenner, wird nun ein Parametertest an den LEDs durchgeführt. Dazu wird die gesamte Anordnung z.B. über einen Nadeladapter mit einem Strom Ig beaufschlagt und es werden die einzelnen LED-Zweigströme I1 ... In gemessen. Dies kann entweder über einen zusätzlichen Widerstand im LED-Zweig oder über eine Helligkeitsmessung direkt an den einzelnen LEDs erfolgen, wobei die Helligkeitsmessung den Vorteil eines geringeren Bauteilaufwandes hat, da nicht noch ein zusätzlicher Messwiderstand für jeden Zweig vorgesehen werden muss.

Wird bei dieser Messung eine Asymmetrie festgestellt, d.h. ein Unterschied der einzelnen Zweigströme bzw. LED-Helligkeitswerte, der einen gewissen tolerierbaren Maximalwert überschreitet, so wird der LED-Strom in den LED-Zweigen mit einem zu hohen Zweigstrom bzw. zu hoher Helligkeit dadurch reduziert, dass bei dem zunächst überbrückten Serienwiderstand R1 ... Rn der überbrückende Leiterabschnitt durchtrennt wird und dadurch der entsprechende Serienwiderstand "freigeschaltet" wird. Das Durchtrennen kann beispielsweise in einem Nutzentrenner erfolgen, der als Fräser ausgeführt ist und beispielsweise ein Loch oder Sackloch in die Leiterplatte fräsen kann, um dadurch den Leiterzug bzw. Leiterabschnitt zu durchtrennen. Fig. 2 zeigt einen solchen durchtrennten Leiterabschnitt in Zweig ZW2, in dem zuvor ein zu hoher Strom gemessen wurde. Der freigeschaltete Serienwiderstand R2 reduziert nun den Strom in dem Zweig und nach dem Nutzentrenner sind alle LED-Zweige ausreichend symmetriert, d.h. sie führen in gewissen Toleranzgrenzen den gleichen Strom, so dass auch die Helligkeiten aller LED-Zweige entsprechend gleich bzw. symmetrisch sind.

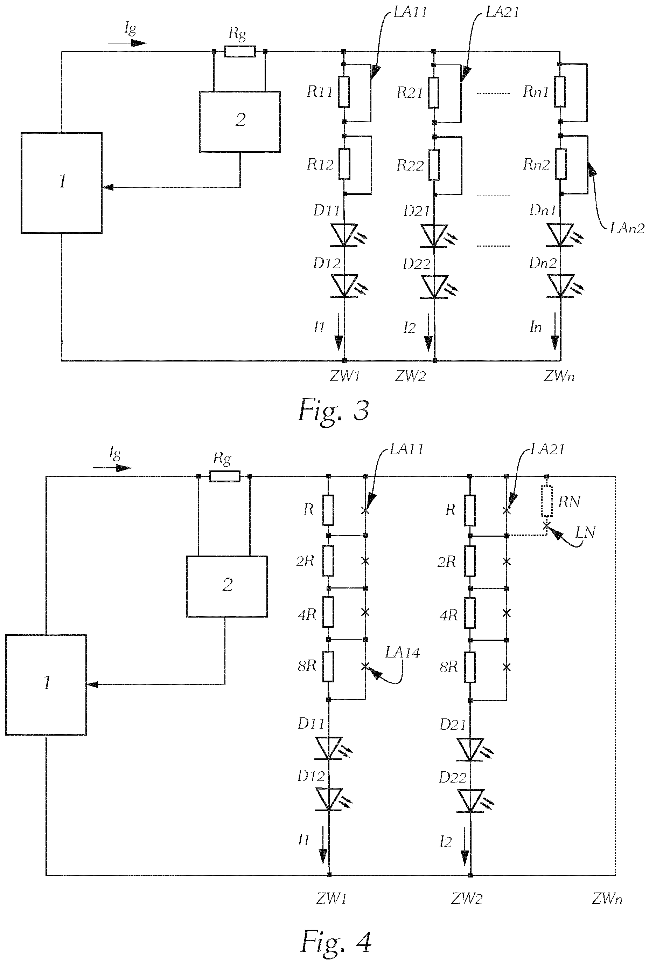

Die Ausführung nach Fig. 3 ist im Prinzip gleich jener nach den Fig. 1 und Fig. 2, sie soll jedoch zeigen, dass man in jedem Zweig mehr als einen Serienwiderstand vorsehen kann. Im vorliegenden Fall sind in jedem Zweig zwei Vorwiderstände R11, R12 ... Rn1, Rn2 vorgesehen. Es ist klar, dass eine höhere Anzahl von Vorwiderständen eine genauere Symmetrierung erlaubt. Im vorliegenden Beispiel der Fig. 3 können, sofern die Widerstandswerte der in Serie liegenden Vorwiderstände jedes Zweiges unterschiedlich sind, insgesamt vier verschiedene Ströme eingestellt werden.

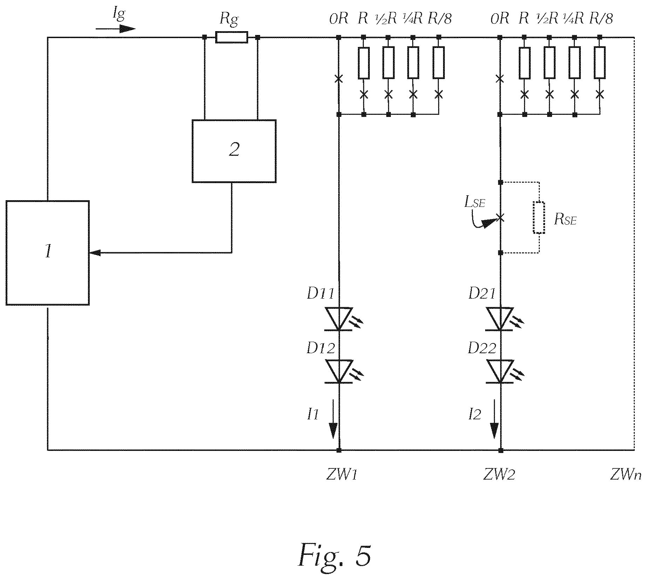

Die folgenden Figuren 4 und 5 sollen zeigen, dass auch andere Kombinationen von Widerständen und diese überbrückenden Leiterabschnitten bis hin zu Widerstandsnetzwerken möglich sind.

Fig. 4 zeigt, dass in jedem Zweig in Serie vier Vorwiderstände mit abgestuften Widerstandswerten R, 2R, 4R und 8R liegen, so dass durch Durchtrennen der je zu den Vorwiderständen parallel liegenden und diese kurzschließenden Leiterabschnitte LA11 ... LA14 usw. eine hohe Anzahl von Kombinationen möglich ist, die entsprechende Vorwiderstandswerte für jeden Zweig ergeben. Für den Zweig ZW2 ist gezeigt, dass ein Serienwiderstand, hier der Widerstand R auch von einem weiteren Widerstand überbrückt sein kann, der hier Nebenwiderstand genannt wird und mit RN bezeichnet ist. Diesem Nebenwiderstand ist in Serie auch ein Leiterabschnitt LN zugeordnet, der durchtrennt werden kann, wodurch die Parallelschaltung des Nebenwiderstandes RN zu dem bisherigen Widerstand R wegfällt. Es ist klar, dass auf diese Weise eine noch feinere Abstufung möglich ist.

Ähnliches, wie den vorhin beschriebenen Nebenwiderstand, zeigt Fig. 5, in welcher in jedem Zweig in Serie zu den LEDs, hier D11 und D12 die Parallelschaltung von vier Widerständen und einem Leiterabschnitt liegt, wobei die Widerstände die Werte R, $\frac{1}{2}R$, $\frac{1}{4}R$, $\frac{1}{8}R$ aufweisen bzw. der kurzschließende Leiterabschnitt den Widerstandswert 0R. Sinngemäß wie bei der Serienschaltung nach Fig. 4 sind hier viele Kombinationsmöglichkeiten für jeden LED-Zweig gegeben. In Fig. 5 ist außerdem im Zweig ZW2 noch ein Serienwiderstand $R_{SE}$ strichliert eingezeichnet, der von einem Leiterabschnitt überbrückt ist, wobei dieser Leiterabschnitt $L_{SE}$ gleichfalls durchtrennt werden kann, um den Serienwiderstand $R_{SE}$ wirksam werden zu lassen.

Die Widerstände RN in Fig. 4 bzw. $R_{SE}$ in Fig. 5 sollen lediglich andeuten, dass im Prinzip auch komplexere Widerstandsnetzwerke unter dem Begriff "zumindest ein Vorwiderstand" verstanden werden sollen, wobei in der Praxis verständlicherweise einfacheren Konfigurationen der Vorzug gegeben wird.

Wenngleich bei den gezeigten Ausführungsformen jeder Zweig zwei LEDs in Serienschaltung enthält, soll dies andere LED-Konfigurationen in jedem Zweig nicht ausschließen. Vor allem ist es bei höheren Bordspannungen in Fahrzeugen, z.B. von 24 oder 48 Volt auch möglich, trotz des Einsatzes von billigen Abwärtswandlern mehr als zwei LEDs in einem Zweig zu verwenden. Ebenso sind prinzipiell in jedem Zweig Kombinationen von Serien- und Parallelschaltungen von LEDs möglich.

Das Durchtrennen von Leiterbahnen kann selbstverständlich auch getrennt von dem Zuschneiden eines Nutzens erfolgen, wobei speziell bei einem Aufbau auf Leiterplatten das Durchtrennen vorteilhafterweise mittels eines Laserwerkzeugs erfolgen kann.

**Patentansprüche**

1. Verfahren zum Symmetrieren von Zweig-Strömen in parallelgeschalteten Zweigen einer Beleuchtungseinrichtung für Fahrzeuge im Zuge der Fertigung aufweisend eine Anordnung aufweisend zumindest zwei parallelgeschaltete LED-Zweige (ZW1, ZW2 ... ZWn), wobei jeder parallelgeschaltete LED-Zweig in Serienschaltung zumindest einen Vorwiderstand (R1 ... Rn) und zumindest eine LED (D11 ... Dn2) aufweist, wobei der zumindest eine Vorwiderstand (R1 ... Rn) jedes auf einer Leiterplatte angeordneten LED-Zweiges der parallelgeschalteten LED-Zweige durch einen auf der Leiterplatte vorgesehenen Leiterzug (LA1 ... LAn) überbrückt ist, wobei jeder dieser Leiterzüge (LA1 ... LAn) für ein Werkzeug zugänglich ist und mit dessen Hilfe durchtrennbar ist, wobei das Werkzeug ein Nutzentrenner für Leiterplatten ist,

   wobei nach der Bestückung der Leiterplatte, jedoch vor einer Vereinzelung der Leiterplatte im Nutzentrenner ein Parametertest an den LEDs (D11 ... Dn2) durchgeführt wird, indem ein Gesamtstrom (Ig) an die Anordnung abgegeben wird und dabei der jeweilige Zweig-Strom (I1, I2, In) durch jeden der parallelgeschalteten LED-Zweige oder die Helligkeit zumindest einer LED (D11 ... Dn2) in jedem parallelgeschalteten LED-Zweig gemessen wird, und wobei in jedem der LED-Zweige der parallelgeschalteten LED-Zweig/e, in welchem der gemessene Strom oder die gemessene Helligkeit einen festlegbaren Grenzwert überschreitet, der jeweilige überbrückende Leiterzug (LA1 ... Lan) des zumindest einen Vorwiderstandes mit Hilfe des Werkzeuges durchtrennt wird.

2. Verfahren nach Anspruch 1, **dadurch gekennzeichnet, dass** eine Serienschaltung des jeweiligen auf der Leiterplatte angeordneten durchtrennbaren Leiterzugs (LA1 ... Lan) und eines jeweiligen Nebenwiderstandes (RN) dem jeweiligen Vorwiderstand (R) parallel geschaltet ist.

3. Verfahren nach Anspruch 1 oder 2, **dadurch ge-**

**kennzeichnet, dass** jeder LED-Zweig der parallelgeschalteten LED-Zweige (ZW1 ... ZWn) zumindest zwei in Serie liegende Vorwiderstände (R11, R12 ... Rn1, Rn2) aufweist, wobei zumindest einer der zumindest zwei Vorwiderstände jedes parallelgeschalteten LED-Zweiges durch jeweils einen auf einer Leiterplatte vorgesehenen durchtrennbaren Leiterzug (LA11 ... LAn2) überbrückt ist.

4. Verfahren nach einem der Ansprüche 1 bis 3, **dadurch gekennzeichnet, dass** als der Nutzentrenner ein Fräser für Leiterplatten verwendet wird.

**Claims**

1. Method for balancing branch currents in parallel-connected branches of a lighting device for vehicles in the course of manufacture, comprising an arrangement having at least two parallel-connected LED branches (ZW1, ZW2 ... ZWn), each parallel-connected LED branch having at least one series resistor (R1 ... Rn) and at least one LED (D11 ... Dn2) connected in series, the at least one series resistor (R1 ... Rn) of each LED branch of the parallel-connected LED branches arranged on a printed circuit board being bridged by a conductor run (LA1 ... LAn) provided on the printed circuit board, each of these conductor runs (LA1 ... LAn) being accessible to a tool and being able to be severed with the aid of the latter, the tool being a depaneling tool for printed circuit boards,

wherein after the assembly of the printed circuit board, but before a separation of the printed circuit board in the depaneling device, a parameter test is carried out on the LEDs (D11 ... Dn2) by supplying a total current (Ig) to the arrangement and thereby measuring the respective branch current (11, 12, In) through each of the parallel-connected LED branches or the brightness of at least one LED (D11 ... Dn2) in each parallel-connected LED branch,
and wherein in each of the LED branches of the parallel-connected LED branch(s) in which the measured current or the measured brightness exceeds a definable limit value, the respective bridging conductor path (LA1 ... Lan) of the at least one series resistor is cut by means of the tool.

2. Method according to claim 1, **characterized in that** a series circuit of the respective separable conductor path (LA1 ... Lan) arranged on the printed circuit board and of a respective shunt resistor (RN) is connected in parallel with the respective series resistor (R).

3. Method according to claim 1 or 2, **characterized in that** each LED branch of the parallel-connected LED branches (ZW1 ... ZWn) has at least two series-connected series resistors (R11, R12 ... Rn1, Rn2), at least one of the at least two series resistors of each parallel-connected LED branch being bridged by in each case one severable conductor run (LA11 ... LAn2) provided on a printed circuit board.

4. Method according to one of claims 1 to 3, **characterized in that** a router for printed circuit boards is used as the depaneling device.

**Revendications**

1. Procédé de symétrisation de courants de branche dans des branches montées en parallèle d'un dispositif d'éclairage pour véhicules en cours de fabrication, comprenant un agencement présentant au moins deux branches de DEL montées en parallèle (ZW1, ZW2 ... ZWn), chaque branche de DEL montée en parallèle comprenant, en montage en série, au moins une résistance série (R1 ... Rn) et au moins une DEL (D11 ... Rn), l'au moins une résistance série (R1 ... Rn) de chaque branche de LED disposée sur une carte de circuit imprimé des branches de LED montées en parallèle étant pontée par un conducteur (LA1 ... LAn) prévu sur la carte de circuit imprimé, chacun de ces conducteurs (LA1 ... LAn) étant accessible à un outil et pouvant être sectionné à l'aide de celui-ci, l'outil étant un séparateur utile pour cartes de circuit imprimé,

dans lequel, après l'équipement de la carte de circuit imprimé, mais avant une séparation de la carte de circuit imprimé dans le séparateur utile, un test de paramètre est effectué sur les DEL (D11 ... Dn2) en délivrant un courant total (Ig) à l'agencement et en mesurant le courant de branche respectif (11, 12, In) à travers chacune des branches de DEL connectées en parallèle ou la luminosité d'au moins une DEL (D11 ... Dn2) dans chaque branche de DEL connectée en parallèle,
et dans lequel, dans chacune des branches LED de la/des branche(s) LED connectée(s) en parallèle, dans laquelle le courant mesuré ou la luminosité mesurée dépasse une valeur limite pouvant être fixée, le conducteur de pontage respectif (LA1 ... Lan) de l'au moins une résistance série est sectionné à l'aide de l'outil.

2. Procédé selon la revendication 1, **caractérisé en ce qu'**un montage en série de la ligne conductrice séparable respective (LA1 ... Lan) disposée sur le circuit imprimé et d'une résistance auxiliaire respective (RN) est monté en parallèle avec la résistance série respective (R).

3. Procédé selon la revendication 1 ou 2, **caractérisé en ce que** chaque branche de LED des branches de LED connectées en parallèle (ZW1 ... ZWn) présente au moins deux résistances série (R11, R12 ... Rn1, Rn2), au moins l'une des au moins deux résistances série de chaque branche de LED connectée en parallèle étant pontée par un conducteur séparable respectif (LA11 ... LAn2) prévu sur une carte de circuit imprimé.

4. Procédé selon l'une des revendications 1 à 3, **caractérisé en ce que** l'on utilise comme séparateur utile une fraise pour circuits imprimés.

*Fig. 1*

*Fig. 2*

EP 3 295 772 B1

Fig. 3

Fig. 4

*Fig. 5*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013111510 A1
- US 6172480 B1
- WO 2014023742 A2
- EP 0942474 A2